# EUROPEAN PATENT APPLICATION

(11) **EP 0 615 185 A1**
(43) Date of publication of application: **14.09.1994**
(21) Application number: 93309262.9
(22) Date of filing: 22.11.1993
(51) Int. Cl.: G06F 3/153

(54) **Integrated computer terminal**

(30) Priority: 08.03.1993 US 47563
(71) Applicant: TEKTRONIX, INC., Wilsonville, Oregon 97070-1000 (US)
(72) Inventor: Denham, Dan F., Newberg, Oregon 97132 (US); Terada, Frank T., Oregon 97007 (US); Brown, David Jerome, Sherwood, Oregon 97140 (US)
(74) Representative: Wombwell, Francis

(57) **Abstract**

An integrated computer terminal integrates both mechanically and electrically a computer terminal with a monitor. A first circuit board contains computer terminal logic electronics and output video amplifiers from the monitor display electronics, with the output video amplifiers providing an RGB signal for display on a monitor display device. A second circuit board contains a power supply for both circuit boards, and contains deflection circuitry. The computer terminal logic electronics from the first circuit board provides video sync signals directly to the deflection circuitry on the second circuit board, which in turn provides deflection signals for the monitor display device. A single, EMI-shielded housing contains the circuit boards and the monitor display device.

## Description

### Background of the Invention

The present invention relates to computer terminals, and more particularly to an integrated computer terminal that integrates computer terminal logic electronics with the monitor display electronics.

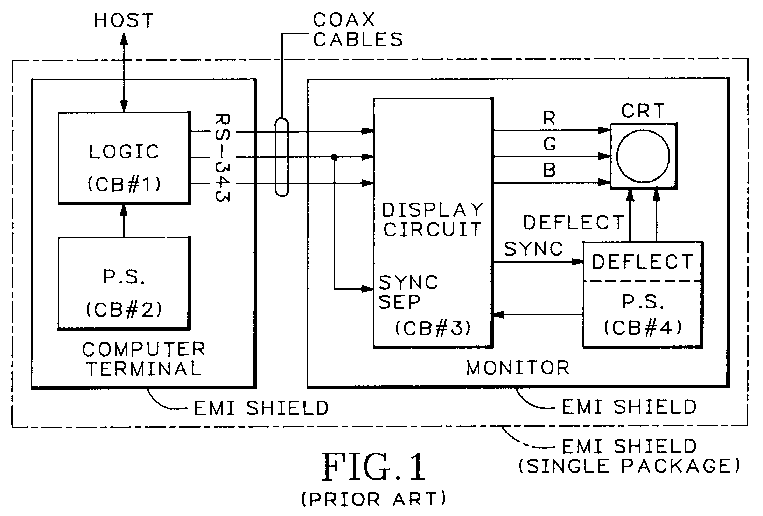

Currently computer terminals are used in conjunction with monitors and are generally contained in separate cabinets. The computer terminal is accessed by a keyboard or other standard interface device and transmits analog voltages, representing the RGB color components and sync for a video signal, to the monitor in a standard format, such as RS-343, over a coaxial cable. The requirement of providing the video in the standard format results in the use of encoders, which further complicates the circuitry within the computer terminal. The RGB components are input to video amplifiers as part of the display electronics in the monitor and the sync is separated from the RGB components to drive a deflection circuit so that the video signal is displayed as an image on a monitor display device, such as a CRT. A block diagram of this terminal configuration is shown in Fig. 1. The monitor includes the display device and at least two circuit boards -- one board containing a power supply and the deflection circuit and another board containing the video amplifiers. The monitor also includes front panel controls for brightness and contrast that provide signals that affect the gain and d.c. offset of the video amplifiers, and may include a display microprocessor as part of the display electronics. The computer terminal includes at least two circuit boards -- one for a power supply and another for the logic circuitry that includes a microprocessor, a frame buffer and a digital to analog converter.

The separate cabinets, one for the computer terminal and the other for the monitor, with separate EMI shields result in potential EMI problems when the video signal leaves the computer terminal and enters the monitor. Various attempts, including special cabling, have been made to overcome these problems. In some instances the elimination of separate cabinets has been implemented by mechanically placing the monitor and computer terminal within a common cabinet with a single EMI shield. However no electrical integration has been attempted so that there are still at least four circuit boards in the integrated cabinets. Finally for monitors that provide digital controls for contrast and brightness there is the separate display microprocessor within the monitor.

What is desired is an integrated computer terminal that has integrated electronics within a single, EMI-shielded cabinet to reduce hardware requirements and EMI problems.

### Summary of the Invention

Accordingly the present invention provides an integrated computer terminal that reduces the number of circuit boards required in a terminal/monitor system by one-half. The logic electronics for the computer terminal, which include a microprocessor, a frame buffer and a video digital to analog converter, and the video amplifiers from the display electronics of the monitor are placed on a single circuit board so that no standard video format, and the associated special cabling, is required between the logic electronics and the display electronics. The combined logic/video amp board replaces the prior display electronics board in the monitor. The power supply on the power supply/deflection board for the monitor is modified to provide the additional power and voltage levels required for the logic electronics. Monitor controls, such as brightness and contrast, are provided as digital inputs to the digital peel data stored in the frame buffer so that all adjustments to the video signals are performed in the digital domain. Also sync information is provided separately to the deflection circuit on the power supply/deflection board from the logic electronics, eliminating the requirement of a sync separator circuit.

The objects, advantages and other novel features of the present invention are apparent from the following detailed description when read in conjunction with the appended claims and attached drawing.

### Brief Description of the Drawing

Fig. 1 is a block diagram of a prior art computer terminal/monitor system.

Fig. 2 is a block diagram of an integrated computer terminal according to the present invention.

### Description of the Preferred Embodiment

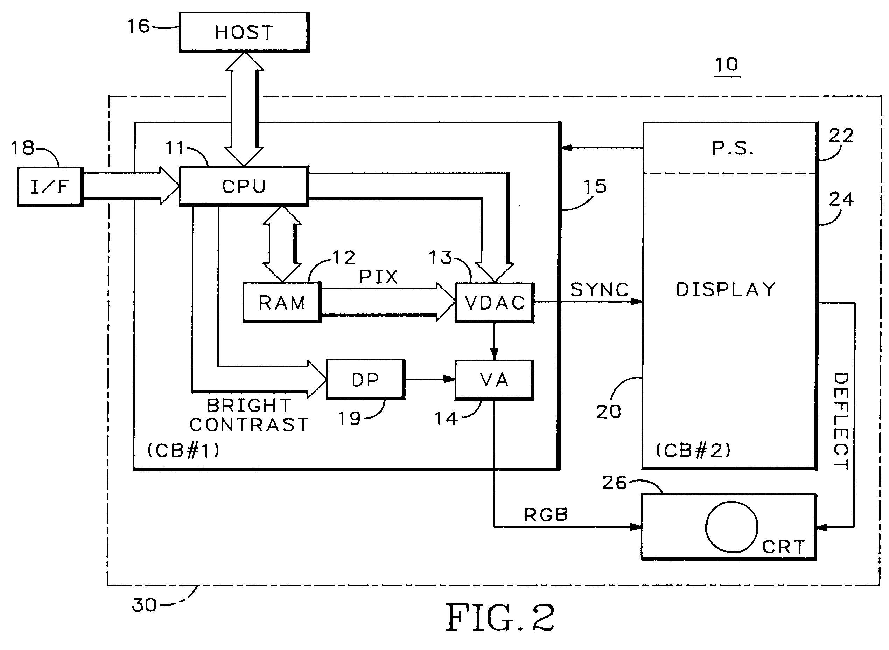

Referring now to Fig. 2 a computer terminal **10** has logic electronics, including a microprocessor (CPU) **11**, a frame buffer memory (RAM) **12** and a video digital to analog converter (VDAC) **13**, that is incorporated onto a first circuit board (CB#1) **15**. The first circuit board **15** also includes output video amplifiers (VA) **14**. The CPU **11** interfaces with a host computer **16** and with an interface device **18**, such as a keyboard, mouse, or the like, as is well known in the art. The RAM **12** contains an image in the form of digital pixel data to be displayed. The digital peel data are input to the VDAC **13** which converts the digital pixel data into analog color component signals, such as red, green and blue (RGB) signals. The RGB signals are input to the video amplifiers **14** using standard circuit board technology without the need for special cabling. The VDAC **13** also provides video synchronization signals to a second circuit board (CB#2) **20** in response to video timing signals from the CPU **11**. The second circuit board **20** contains a power supply **22** and display circuitry **24** which generates from the video synchronization signals deflection signals for a monitor display device **26**, such as a cathode ray tube (CRT). The power supply **22** provides the power requirements for both circuit boards **15**, **20** and the monitor display device **26**. The outputs from the video amplifiers **14** are applied to the CRT **26** together with the deflection signals from the display circuitry **24** to reproduce the image contained in RAM **12**. A single EMI shield **30** surrounds the two circuit boards **15**, **20**. Display control signals, such as brightness, contrast, position, etc., input via the interface circuit **18**, are processed by the CPU **11** in digital form. These display control signals are input to digital potentiometers **19** to produce analog display signals that are input to the VAs **14**.

Thus the present invention provides an integrated computer terminal that integrates both mechanically and electrically computer terminal logic electronics, including a microprocessor, frame buffer memory and video digital to analog converter, with video amplifiers from monitor display electronics on one circuit board, and on a second circuit board the power supplies for both circuit boards as well as the display circuitry for generating deflection signals for a monitor display device, the two circuit boards and monitor display device being enclosed in a single, EMI-shielded housing.

## Claims

1. An integrated computer terminal (**10**) comprising:
a first circuit board (**15**) having computer terminal logic electronics, including a microprocessor (**11**) for interfacing with a host computer (**16**), a frame buffer (**12**) for storing from the microprocessor an image for display as digital peel data, and a video digital to analog converter (**13**) for, in response to video timing signals from the microprocessor, converting the digital peel data into analog color component signals and generating video sync signals, and having output video amplifiers (**14**) that provide the analog color component signals to a monitor display device (**26**);
a second circuit board (**20**), including a power supply (**22**) and deflection circuitry (**24**), the power supply providing required power for both circuit boards and the deflection circuitry receiving the video sync signals to provide deflection signals for the monitor display device; and
a single, EMI-shielded housing (**30**) within which the circuit boards are mounted together with the monitor display device.

2. The integrated computer terminal as recited in claim 1 further comprising means for producing display control data in response to operator input display control commands, which display control data are combined with the digital pixel data in the frame buffer.
